# EUROPEAN PATENT SPECIFICATION

(11) **EP 0 759 230 B1**
(45) Date of publication and mention of the grant of the patent: **22.12.2004**
(21) Application number: 96908502.6
(22) Date of filing: 01.03.1996
(51) Int. Cl.: H03G 3/00, H03F 3/72

(54) **CMOS PROGRAMMABLE RESISTOR-BASED TRANSCONDUCTOR**
CMOS-PROGRAMMIERBARE TRANSKONDUKTANZSCHALTUNG MIT WIDERSTÄNDEN
TRANSCONDUCTEUR CMOS PROGRAMMABLE A RESISTANCES

(30) Priority: 01.03.1995 US 396994; 14.03.1995 US 403359
(43) Date of publication of application: 26.02.1997
(73) Proprietor: LATTICE SEMICONDUCTOR CORPORATION, Hillsboro, Oregon 97124 (US)
(72) Inventor: GORECKI, James, L., Hillsboro, OR 97124 (US); YANG, Yaohua, Hillsboro, OR 97124 (US)
(74) Representative: Atkinson, Ralph
(86) International application number: PCT/US1996/002399
(87) International publication number: WO 1996/027239

(56) References cited:
- EP-A- 0 492 431
- EP-A- 0 510 704
- US-A- 4 667 166
- EDN ELECTRICAL DESIGN NEWS, vol. 32, no. 2, 22 January 1987, NEWTON, MASSACHUSETTS US, pages 181-187, XP002006806 A. KANIEL: "FLEXIBLE PGA DESIGNS REQUIRE FEW COMPONENTS"

## Description

The present invention relates to a programmable transconductor for generating a differential current between a first current output terminal and a second current output terminal, wherein said differential current is responsive to a differential voltage operably impressed between a first voltage input terminal and a second voltage input terminal, wherein a current source circuit is configured to deliver a predetermined amount of current into each of a first summing node and second summing node; a first gain block has a first input coupled to said first voltage input terminal, a second input coupled to a first feedback node and an output; a first transistor has a first current-handling terminal coupled to the first summing node, a second current-handling terminal coupled to said first current output terminal and a control terminal coupled to the output of said first gain block; a second gain block has a first input coupled to said second voltage input terminal, a second input coupled to a second feedback node and an output; and a second transistor has a first current-handling terminal coupled to a second summing node, a second current-handling terminal coupled to said second current output terminal and a control terminal coupled to the output of said second gain block; and a resistor circuit is coupled between said first summing node and said second summing node, said resistor circuit comprising a plurality of individual resistors connected in series and defining a plurality of intermediate nodes between adjacent resistors

A transconductor is a circuit which receives an input voltage and generates an output current. The magnitude of the output current is proportional to the input voltage received, and the ratio by which the output current changes for a given ratio of input voltage change is known as the conversion gain, or transconductance (Gₘ = Δl_{OUT} *l* ΔV_{IN}) of the transconductor. A differential transconductor receives a differential voltage impressed between two voltage input terminals, and generates a differential current between two current output terminals. The common-mode voltage of the two voltage input terminals is ignored. In other words, a first current is generated on one of the current output terminals, and a second current is generated on the other current output terminal, and the difference between the first and second currents is known as the differential current appearing at the pair of current output terminals.

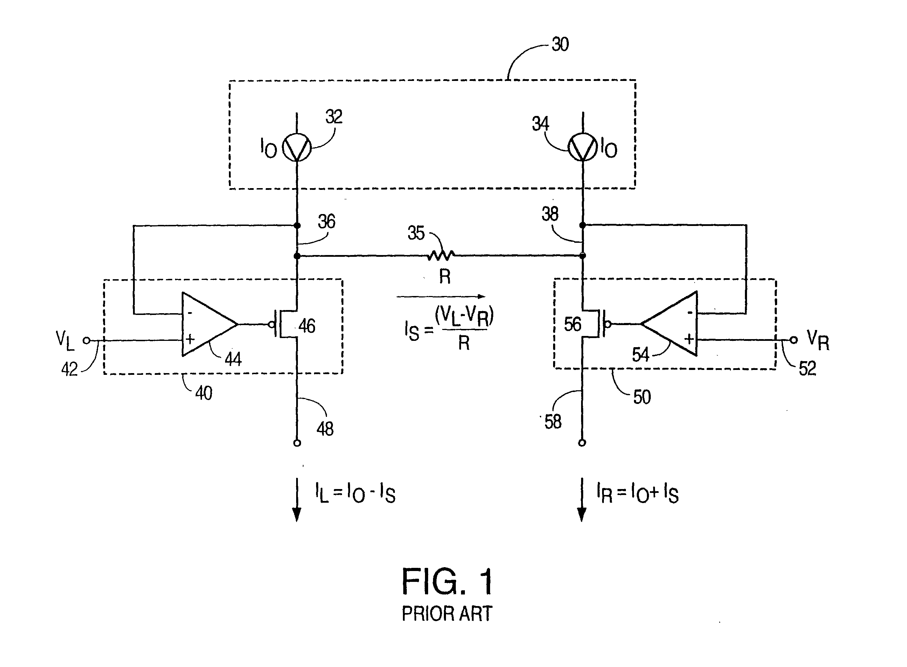

A differential transconductor known in the art is shown in Fig. 1. A differential input voltage, V_{L} - V_{R}, is received between voltage input terminals 42 and 52, and a corresponding differential output current is generated between current output terminals 48 and 58. A current source circuit 30 includes a current source 32 which delivers a current of magnitude I_{O} into summing node 36 and further includes a current source 34 which delivers a current of magnitude I_{O} into summing node 38. Input circuit 40, which enhances the transconductance of transistor 46, includes an op-amp 44 having a non-inverting input coupled to the voltage. input terminal 42 and an inverting input coupled to the summing node 36. The output of op-amp 44 drives the gate of transistor 46, which is a P channel MOS transistor. Transistor 46 couples summing node 36 to the current output terminal 48. A second input circuit 50, which enhances the transconductance of transistor 56, includes an op-amp 54 having a non-inverting input coupled to the voltage input terminal 52 and an inverting input coupled to summing node 38. The output of op-amp 54 drives the gate of transistor 56, which is also a P channel MOS transistor. Transistor 56 couples summing node 38 to the current output terminal 58. A resistor 35 having a resistance of R ohms couples summing node 36 to summing node 38. As is common with differential circuits, current source 32 and input circuit 40 are matched to current source 34 and input circuit 50, respectively, to provide balanced differential operation.

The operation of this circuit can best be understood by looking initially at the left-most portion. Input circuit 40 functions to force the voltage of summing node 36 to follow the input voltage, V_{L}, received on voltage input terminal 42. This occurs because the op-amp 44 drives the gate of transistor 46 to a suitable voltage such that the voltage of summing node 36, which is coupled to the inverting input of op-amp 44, follows the input voltage, V_{L}, coupled to the non-inverting input of op-amp 44. For example, if the voltage of summing node 36 is too high, the output of op-amp 44 is driven lower, thus providing more gate drive to P channel transistor 46. Consequently, a higher current flows through transistor 46 which lowers the voltage of summing node 36 until the voltage at summing node 36 is equal to the voltage at non-inverting input terminal of op-amp 44. Similarly, for the right-most portion, input circuit 50 functions to force the voltage of summing node 38 to follow the input voltage, V_{R}, received on voltage input terminal 52 of op-amp 54. This occurs because the op-amp 54 drives the gate of transistor 56 to a suitable voltage such that the voltage of summing node 38, which is coupled to the inverting input of op-amp 54, follows the input voltage, V_{R}, coupled to the non-inverting input of op-amp 54. Thus, with the voltage of summing node 36 following input voltage V_{L} and the voltage of summing node 38 following input voltage V_{R}, the differential input voltage V_{L} - V_{R} is placed across resistor 35, and causes a current Iₛ of magnitude (V_{L} - V_{R}) /R to flow from summing node 36 to summing node 38. If V_{R} is greater in magnitude than V_{L} then a negative current Iₛ flows from summing node 36 to summing node 38 which, of course, is equivalent to a positive current flow from summing node 38 to summing node 36.

Summing node 36 receives a current l_{O} from current source 32, and sources a current Iₛ flowing into summing node 38. Thus, the net current which is provided to the source of transistor 46 is I_{O} - Iₛ. The current, I_{L}, coupled to current output terminal 48 must also be equal to I_{O} - Iₛ, because the sum of current received into any node must equal zero. Similarly, summing node 38 receives a current l_{O} from current source 34, and receives a current I_{S} flowing from summing node 36. Thus, the net current received into summing node 38 is I_{O} + Iₛ, which is coupled by transistor 56 to the current output terminal 58 as I_{R} = I_{O} + I_{S}.

The topology of this circuit is generally known as a degenerated pair linearized by servo-feedback, and is also known as a linearized resistor-based transconductor. The distortion produced by transistors 46 and 56 is reduced by the loop gain of the op-amps 44, 54, respectively. The use of a resistor in setting the conversion gain of the transconductor results in high linearity, but also results in a conversion gain which is fixed by the choice of resistor value, and which varies with semiconductor process parameter variations. Notwithstanding these advantages, additional flexibility is desired to allow a wider variety of usage. In particular, a programmable transconductor would allow selecting the desired conversion gain after semiconductor manufacturing.

A differential amplifier system having a pair of transistors with their collectors connected respectively to a pair of system output terminals is disclosed in United States Patent 4,667,166. In addition, the transistor bases are connected respectively to a pair of system input terminals via a pair of capacitors and their emitters are interconnected via a resistor. However, the interconnecting resistor is of fixed resistance and therefore cannot be used to modify operational characteristics.

According to an aspect of the present invention, there is provided a programmable transconductor for generating a differential current between a first current output terminal and a second current output terminal, of the aforesaid type, characterised by a first plurality of switch circuits, each having a first terminal coupled to a corresponding node of the resistor circuit and each further having a second terminal coupled to the first feedback node (**60**); and a second plurality of switch circuits (**S1, S2, S3**), each having a first terminal coupled to a corresponding node (**38, 77, 78**) of the resistor circuit, and each further having a second terminal coupled to the second feedback node (**70**); wherein the resistor circuit and the plurality of switch circuits are configured to provide a programmable transconductance gain.

In a preferred embodiment, the plurality of individual resistors comprises a first group of resistors connected in series and defining a first group of intermediate nodes associated therewith; a second group of resistors connected in series and defining a second group of intermediate nodes associated therewith; a middle resistor coupled between said first group and said second group, wherein each of said first plurality of switch circuits is coupled to a respective one of said first group of intermediate nodes; and each of said second plurality of switch circuits is coupled to a respective one of said second group of intermediate nodes.

Preferably, the first and second groups of resistors are balanced.

In a preferred embodiment, the first and second plurality of switch circuits comprise CMOS transfer gate circuits that may be enabled by digital control signals.

Preferably, each of the first and second transistors comprises a transistor chosen from a group consisting of P channel MOS transistors, N channel MOS transistors, PNP bipolar transistors and NPN bipolar transistors.

Preferably, the first transistor comprises a P channel MOS transistor having a source/drain terminal coupled to the first summing node, a gate terminal coupled to the output of the first gain block, and a drain/source terminal coupled to the first current output terminal; and wherein the second transistor comprises a P channel MOS transistor having a source/drain terminal coupled to the second summing node, a gate terminal coupled to the second summing node, a gate terminal coupled to the output of the second gain block, and a drain/source terminal coupled to the second current output terminal. Preferably, the first and second groups of resistors are balanced and the first and second plurality of switch circuits comprise CMOS transfer gate circuits enabled by digital control signals.

The invention will now be described by way of example only, with reference to the accompanying drawings, of which:
*Fig. 1* is a schematic diagram of a prior art differential transconductor;
*Fig. 2* is a schematic diagram of a transconductor in accordance with the current invention;
*Fig. 3* is a schematic diagram of a switch circuit of the selector circuit of the *Fig. 2* transconductor in accordance with the present invention;
*Fig. 4* is a schematic diagram of an alternative circuit useful for the transconductor shown in *Fig. 2*;
*Fig. 5* is a schematic diagram of an alternative input circuit useful for the transconductor shown in *Fig. 2*; and
*Fig. 6* is a schematic diagram of another alternative input circuit useful for the transconductor shown in *Fig. 2.*

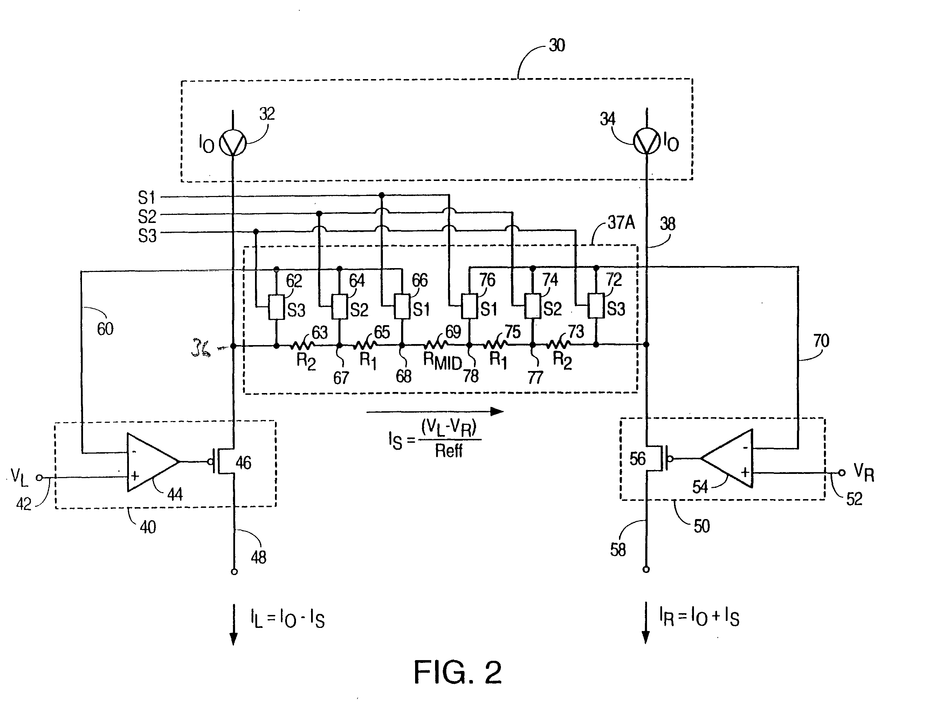

One embodiment of a differential transconductor in accordance with the present invention is shown in *Fig. 2*. A differential input voltage, V_{L} - V_{R}, is received between voltage input terminals **42** and **52,** and a corresponding differential output current is generated between current output terminals **48** and **58.** A current source circuit **30** includes a current source **32** which delivers a current of magnitude l_{O} into summing node **36** and further includes a current source **34** which delivers a current of magnitude I_{O} into summing node **38.** Input circuit **40** includes an op-amp **44** (functioning as a gain block) having a non-inverting input coupled to the voltage input terminal **42** and an inverting input coupled to a first feedback node **60.** The output of op-amp **44** drives the gate of transistor **46**, which in this embodiment is a P channel MOS transistor. Transistor 46 couples summing node 36 to the current output terminal 48. A second bias circuit 50 includes an op-amp 54 having a non-inverting input coupled to the voltage input terminal 52 and an inverting input coupled to a second feedback node 70. The output of op-amp 54 drives the gate of transistor 56, which in this embodiment is also a P channel MOS transistor. Transistor 56 couples summing node 38 to the current output terminal 58.

Circuit 37A includes a selector circuit having an array of switch circuits and includes a resistor circuit having a total resistance of R ohms coupling summing node 36 to summing node 38, and which resistor circuit includes resistors 63, 65, 69, 75, and 73 connected in series and defining a group of intermediate nodes 67, 68, 78, and 77 respectively therebetween. These intermediate nodes, together with summing nodes 36 and 38, form a group of tap nodes of the resistor circuit.

The selector circuit includes an array of switch circuits. Switch circuit 62 couples summing node 36 to feedback node 60 when enabled by logical signal S3. Switch circuit 64 couples intermediate node 67 to feedback node 60 when enabled by logical signal S2, and switch circuit 66 couples intermediate node 68 to feedback node 60 when enabled by logical signal S1. Similarly, switch circuit 72 couples summing node 38 to feedback node 70 when enabled by logical signal S3, switch circuit 74 couples intermediate node 77 to feedback node 70 when enabled by logical signal S2, and switch circuit 76 couples intermediate node 78 to feedback node 70 when enabled by logical signal S1. Logical signals S1, S2, and S3 are preferably digital control signals which select the desired transconductance of the circuit, but may also be a hardwired or some other fixed connection.

The operation of this embodiment can best be understood by first assuming (for example) that logical signal S2 is active, and thus switch circuits 64 and 74 are enabled and remaining switch circuits 62, 66, 72, and 76 are disabled. Since intermediate node 67 is coupled to feedback node 60 which is coupled to the inverting input of op-amp 44, input circuit 40 functions to force the voltage of feedback node 60 and intermediate node 67 to follow the voltage, V_{L} , received on voltage input terminal 42. Assuming V_{L} is greater than V_{R} and thus I_{S} is positive, op-amp 44 drives the gate of transistor 46 to a suitable voltage such that the voltage of summing node 36 is driven to a voltage *higher* than V_{L}, so that the voltage of feedback node 60, which is coupled to the inverting input of op-amp 44, follows the input voltage V_{L}. Due to the high input impedance of op-amp 44, virtually no DC current flows through switch circuit 64 and consequently the voltage of feedback node 60 follows the voltage of intermediate node 67 with negligible voltage drop, noise, or distortion effects.

Similarly, for the right-most portion, input circuit 50 functions to force the voltage of intermediate node 77 to follow the voltage, V_{R} , received on voltage input terminal 52. Thus, with feedback node 60 following input voltage V_{L} and feedback node 70 following input voltage V_{R}, and since no DC current flows through switch circuits 64 and 74 (due to the high input impedance of op-amps 44 and 54), the differential input voltage V_{L} - V_{R} is placed directly across an effective resistance, R_{eff} , consisting of resistors 65, 69, and 75 (since for this discussion logical signal S2 is active). This causes a current I_{S} of magnitude (V_{L} - V_{R}) /R_{eff} to flow from summing node 36 to summing node 38. If V_{R} is greater in magnitude than V_{L} then a negative current I_{S} flows from summing node 36 to summing node 38 which, of course, is equivalent to a positive current flow from summing node 38 to summing node 36.

Summing node 36 receives a current I₀ from current source 32, and sources a current I_{S} flowing into summing node 38. Thus, the net current which is provided to transistor 46 is I₀ - I_{S} , which is then coupled by transistor 46 to the current output terminal 48. Similarly, summing node 38 receives a current I₀ from current source 34, and receives a current I_{S} flowing from summing node 36. Thus, the net current provided to transistor 56 is I₀ + I_{S} , which is then coupled by transistor 56 to the current output terminal 58.

Even though the *magnitude* of the current I_{S} is set by the input differential voltage V_{L} - V_{R} impressed across only the effective resistor, R_{eff} , formed by those resistors connected between the selected tap nodes which are coupled to the feedback nodes 60 and 70, the current I_{S} flows through *all* the series-connected resistors connected between summing nodes 36 and 38 (in this embodiment, resistors 63, 65, 69, 75, and 73).

Because I_{S} = (V_{L} - V_{R})/R_{eff} , higher conversion gain is accomplished by smaller values of effective resistance. Consequently, for this embodiment the highest conversion gain is achieved by enabling S1, and the lowest conversion gain is achieved by enabling S3.

This programmable topology is achieved by using a string of series-connected resistors, with a group of switch circuits to selectively "tap off" two nodes from the string, and to feedback these nodes to the inverting inputs of the op-amps 44 and 54, respectively. In a preferred embodiment, the selected nodes are symetrically displaced around resistor 69. By changing the taps, the value of the effective resistor R_{eff} is varied, with a resultant change in the transconductance Gₘ (which varies as 1/R_{eff}) . Individual switch circuits are enabled by digital control signals which are provided based upon information which is stored in internal or external memory.

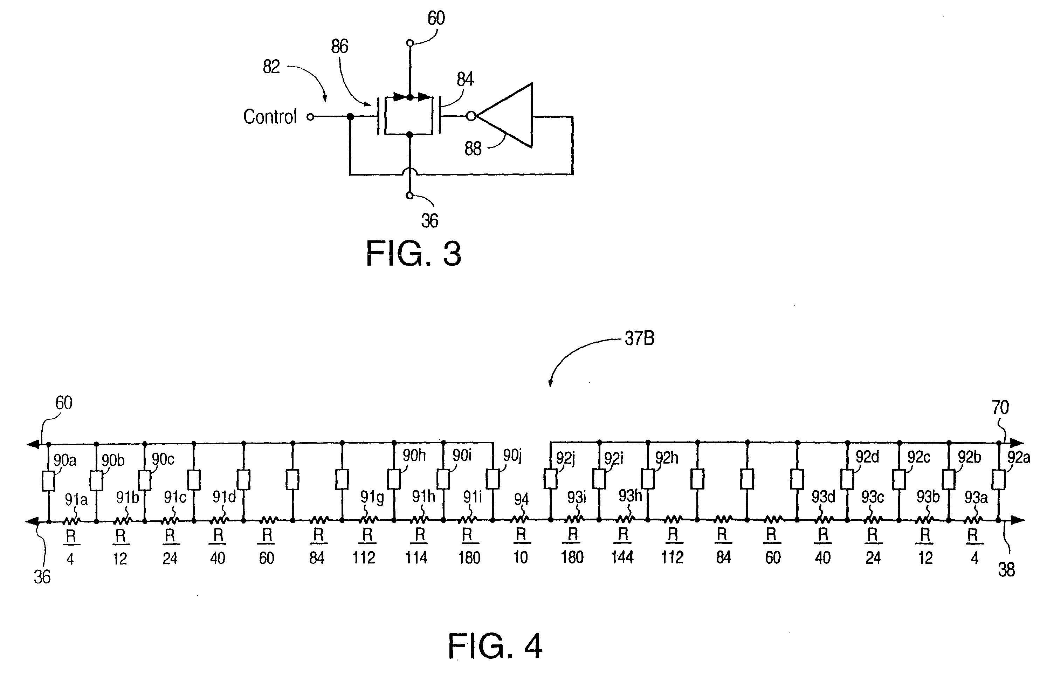

Referring to Fig. 3, switch circuit 62 is shown which is exemplative of switch circuits 64, 66, 72, 74, 76. Switch circuit 62 includes CMOS transfer gates 84, 86 as well as inverter 88 which generates the complement of the switch circuit's enable signal, i.e., the S3 signal.

Referring again to Fig. 2, the distortion produced by transistors 46 and 56 is reduced by the loop gain of op-amps 44, 54, respectively. The use of a group of series-connected resistors in setting the conversion gain of the transconductor results in a high linearity at any gain setting. Since the gain is programmable by selectively enabling a corresponding pair of switch circuits, the gain is not fixed by the choice of single resistor value. Further, resistor matching within a single silicon integrated circuit ensures that the ratio of transconductances is accurate to less than 3%.

Preferably, as this circuit is a balanced differential circuit, the left-hand and right-hand resistors associated with each tap (e.g., resistors 65 and 75 being associated with enable signal S2 which enables switch circuits 64 and 74, respectively) have the same value, i.e., are balanced. The number of taps within the resistor string is not fundamentally limited, although for high frequency operation the parasitic capacitances associated with MOS switches or resistors may degrade performance. The resistors may be sized to produce any monotonic function. The resistors are preferably implemented as either thin film or polysilicon resistors when in an integrated circuit implementation.

Referring to Fig. 4, a preferred embodiment of the resistor circuit is shown. Summing node 36 is coupled to summing node 38 by a string of resistors including resistors 91a through 91i, resistor 94, and resistors 93a through 93i, having an aggregate resistance value, Rₜₒₜₐₗ, for example, of 100 Kohms. By selecting the taps off of the resistor string, the effective transconductance of the transconductor may be programmably varied between G_{M} = 1 to G_{M} = 10.

More specifically, resistors 91a and 93a have a resistance of R/4 ohms, resistors 91b and 93b have a resistance of R/12 ohms, resistors 91c and 93c have a resitance of R/24 ohms, resistors 91d and 93d have a resistance of R/40 ohms, resistors 91e and 93e have a resistance of R/60 ohms, resistors 91f and 93f have a resistance of R/84 ohms, resistors 91g and 93g have a resistance of R/112 ohms, resistors 91h and 93h have a resistance of R/144 ohms, resistors 91i and 93i have a resistance of R/180 ohms and resistor 94 has a value of R/10.

For any of these embodiments, op-amps 44 and 54 may be implemented in a variety of technologies and topologies, and the particular implementation is not pertinent to the operation of the transconductor. For example, CMOS folded cascode circuits and CMOS two-stage amplifier circuits may be used, as well as bipolar implementations or BiCMOS implementations. As long as the input impedance relatively high, e.g., <10⁸ ohms, the implementation details of the op-amps are not significant to the programmability aspect of the transconductor circuit.

A transistor may be conceptualized as having a control terminal which controls the flow of current between a first current handling terminal and a second current handling terminal. An appropriate condition on the control terminal causes a current to flow from/to the first current handling terminal and to/from the second current handling terminal. In a bipolar NPN transistor, the first current handling terminal is the collector, the control terminal is the base, and the second current handling terminal is the emitter. A sufficient current into the base causes a collector-to-emitter current to flow. In a bipolar PNP transistor, the first current handling terminal is the emitter, the control terminal is the base, and the second current handling terminal is the collector. A current exiting the base causes an emitter-to-collector current to flow.

A MOS transistor may likewise be conceptualized as having a control terminal which controls the flow of current between a first current handling terminal and a second current handling terminal. Although MOS transistors are frequently discussed as having a drain, a gate, and a source, in most such devices the drain is interchangeable with the source. This is because the layout and semiconductor processing of the transistor is symmetrical (which is typically not the case for bipolar transistors). For an N-channel MOS transistor, the current handling terminal normally residing at the higher voltage is customarily called the drain. The current handling terminal normally residing at the lower voltage is customarily called the source. A sufficient voltage on the gate causes a current to therefore flow from the drain to the source. The gate to source voltage referred to in an N channel MOS device equations merely refers to whichever diffusion (drain or source) has the lower voltage at any given time. For example, the "source" of an N channel device of a bi-directional CMOS transfer gate depends on which side of the transfer gate is at a lower voltage. To reflect the symmetry of most N channel MOS transistors, the control terminal is the gate, the first current handling terminal may be termed the "drain/source", and the second current handling terminal may be termed the "source/drain". Such a description is equally valid for a P channel MOS transistor, since the polarity between drain and source voltages, and the direction of current flow between drain and source, is not implied by such terminology. Alternatively, one current - handling terminal may be arbitrarily deemed the "drain" and the other deemed the "source", with an implicit understanding that the two are not distinct, but interchangeable.

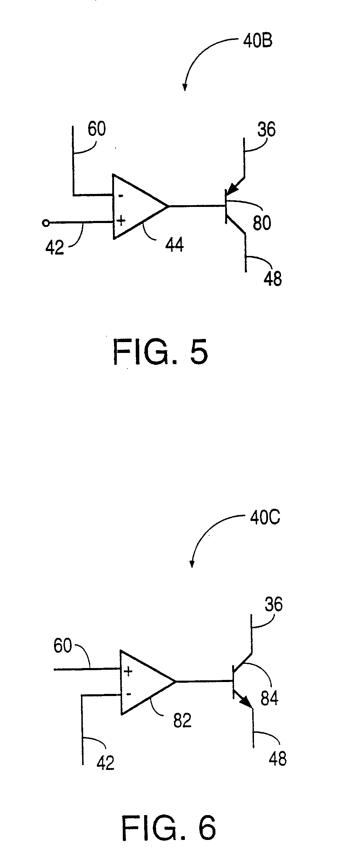

A variety of input circuit configurations may also be utilized with the present invention. The role of transistor 46 and 56 shown in the embodiment of Fig. 2 may be advantageously provided by either N channel or P channel MOS transistors or by NPN or PNP bipolar transistors, with a corresponding reversal of summing nodes and output current nodes. For example, Fig. 5 shows an input circuit 40B which includes an op-amp 44 connected to drive the base of PNP bipolar transistor 80, which couples the net current received into summing node 36 to the current output terminal 48. Alternately, Fig. 6 shows an input circuit 40C which includes an op-amp 82 connected to drive the base of NPN bipolar transistor 84, which couples the net current received into summing node 36 to the current output terminal 48. In this embodiment, the feedback node 60 is connected to the non-inverting input and the voltage input terminal 42 is connected to the inverting input of op-amp 82.

The current source circuit 30 may be advantageously implemented in a number of different ways. Identically biased MOS transistors may be used to achieve the current sources 32 and 34, for example, as in a current mirror configuration. Cascode devices may optionally be used to raise the output impedance of such current sources.

While the invention has been described with respect to the embodiments set forth above, the invention is not necessarily limited to these embodiments. Accordingly, other embodiments, variations, and improvements not described herein are not necessarily excluded from the scope of the invention, which is defined by the following claims.

## Claims

1. A programmable transconductor for generating a differential current between a first current output terminal and a second current output terminal, wherein said differential current is responsive to a differential voltage operably impressed between a first voltage input terminal and a second voltage input terminal, wherein
a current source circuit (**30**) configured to deliver a predetermined amount of current into each of a first summing node and second summing node;
a first gain block (**44**) has a first input coupled to said first voltage input terminal, a second input coupled to a first feedback node (**60**) and an output;
a first transistor (**46**) has a first current-handling terminal coupled to the first summing node, a second current-handling terminal coupled to said first current output terminal and a control terminal coupled to the output of said first gain block;
a second gain block (**54**) has a first input coupled to said second voltage input terminal, a second input coupled to a second feedback node (**70**) and an output; and
a second transistor (**56**) has a first current-handling terminal coupled to a second summing node, a second current-handling terminal coupled to said second current output terminal and a control terminal coupled to the output of said second gain block,
a resistor circuit (**RMID, R1, R2**) is coupled between said first summing node and said second summing node, said resistor circuit comprising a plurality of individual resistors connected in series and defining a plurality of intermediate nodes between adjacent resistors; **characterised by**
a first plurality of switch circuits (**S1, S2, S3**), each having a first terminal coupled to a corresponding node of the resistor circuit (**36, 67, 68**) and each further having a second terminal coupled to the first feedback node (**60**); and
a second plurality of switch circuits (**S1, S2, S3**), each having a first terminal coupled to a corresponding node (**38, 77, 78**) of the resistor circuit, and each further having a second terminal coupled to the second feedback node (**70**); wherein
the resistor circuit and the plurality of switch circuits are configured to provide a programmable transconductance gain.

2. A programmable transconductor according to claim **1**, wherein said plurality of individual resistors comprises
a first group of resistors connected in series and defining a first group of intermediate nodes (**67,68**) associated therewith;
a second group of resistors connected in series and defining a second group of intermediate nodes (**77, 78**) associated therewith;
a middle resistor (RMID) coupled between said first group and said second group, wherein
each of said first plurality of switch circuits is coupled to a respective one of said first group of intermediate nodes; and
each of said second plurality of switch circuits is coupled to a respective one of said second group of intermediate nodes.

3. A programmable transconductor according to claim **2**, wherein the first and second groups of resistors are balanced.

4. A programmable transconductor according to claim **1**, wherein the first and second plurality of switch circuits comprise CMOS transfer gate circuits.

5. A programmable transconductor according to claim **4**, wherein the CMOS transfer gate circuits are enabled by digital control signals..

6. A programmable transconductor according to claim **1** or claim **2**, wherein each of the first inputs of the first and second gain blocks comprises a non-inverting input (**42,45**); and
wherein each of the second inputs of the first and second gain blocks comprises an inverting input.

7. A programmable transconductor according to claim **1**, wherein each of the first and second transistors (**46, 56**) comprises a transistor chosen from a group consisting of P-channel MOS transistors, N-channel MOS transistors, PNP bipolar transistors, and NPN bipolar transistors.

8. A programmable transconductor according to claim **6**, wherein the first transistor comprises a P-channel MOS transistor having a source/drain terminal coupled to the first summing node, a gate terminal coupled to the output of the first gain block, and a drain/source terminal coupled to the first current output terminal; and
wherein the second transistor comprises a P-channel MOS transistor having a source/drain terminal coupled to the second summing node, a gate terminal coupled to the second summing node, a gate terminal coupled to the output of the second gain block, and a drain/source terminal coupled to the second current output terminal.

9. A programmable transconductor according to claim **8**, wherein the first and second groups of resistors are balanced.

10. A programmable transconductor according to claim **9,** wherein the first and second plurality of switch circuits comprise CMOS transfer gate circuits enabled by digital control signals.

## Patentansprüche

1. Programmierbarer Transkonduktor zur Erzeugung eines Differenzstroms zwischen einem ersten Stromausgangsanschluss und einem zweiten Stromausgangsanschluss, wobei der Differenzstrom auf eine im Betrieb zwischen einem ersten Spannungseingangsanschluss und einem zweiten Spannungseingangsanschluss eingeprägte Differenzspannung anspricht, wobei
eine Stromquellenschaltung (30) konfiguriert ist, um eine vorgegebene Strommenge in einen ersten Summierknotenpunkt und in einen zweiten Summerknotenpunkt einzuspeisen;
ein erster Verstärkerblock (44) einen mit dem ersten Spannungseingangsanschluss verbundenen ersten Eingang, einen mit einem ersten Rückkopplungsknotenpunkt (60) verbundenen zweiten Eingang und einen Ausgang aufweist;
ein erster Transistor (46) einen mit dem ersten Summierknotenpunkt verbundenen ersten stromverarbeitenden Anschluss, einen mit dem ersten Stromausgangsanschluss verbundenen zweiten stromverarbeitenden Anschluss und einen mit dem Ausgang des ersten Verstärkerblocks verbundenen Steueranschluss aufweist;
ein zweiter Verstärkerblock (54) einen mit dem zweiten Spannungseingangsanschluss verbundenen ersten Anschluss, einen mit einem zweiten Rückkopplungsknotenpunkt (70) verbundenen zweiten Eingang und einen Ausgang aufweist und
ein zweiter Transistor (56) einen mit einem zweiten Summierknotenpunkt verbundenen stromverarbeitenden ersten Anschluss, einen mit dem zweiten Stromausgangsanschluss verbundenen, stromverarbeitenden zweiten Anschluss und einen mit dem Ausgang des zweiten Verstärkerblocks verbundenen Steueranschluss aufweist,
eine Widerstandsschaltung (RMID, R1, R2) zwischen den ersten Summierknotenpunkt und den zweiten Summierknotenpunkt gekoppelt ist, wobei die Widerstandsschaltung eine Vielzahl von einzelnen Widerständen aufweist, die in Reihe geschaltet sind und eine Vielzahl von dazwischen liegenden Knotenpunkten zwischen benachbarten Widerständen definieren, **gekennzeichnet durch**
eine erste Vielzahl von Schalter-Schaltkreisen (S1, S2, S3), die jeweils einen mit einem entsprechenden Knotenpunkt der Widerstandsschaltung (36, 67, 68) verbundenen ersten Anschluss aufweisen und jeweils weiterhin einen mit dem ersten Rückkopplungsknotenpunkt (60) verbundenen zweiten Anschluss aufweisen; und
eine zweite Vielzahl von Schalter-Schaltkreisen (S1, S2, S3), die jeweils einen mit einem entsprechenden Knotenpunkt (38, 77, 78) der Widerstandsschaltung verbundenen ersten Anschluss aufweisen und weiterhin jeweils einen mit dem zweiten Rückkopplungsknotenpunkt (70) verbundenen zweiten Anschluss aufweisen; wobei
die Widerstandsschaltung und die Vielzahl der Schalter-Schaltkreise konfiguriert sind, um eine programmierbare Transkonduktanzverstärkung bereitzustellen.

2. Programmierbarer Transkonduktor entsprechend Anspruch 1, wobei die Vielzahl der einzelnen Widerstände umfasst:
eine erste Gruppe von Widerständen, die in Reihe geschaltet sind und eine erste Gruppe von zugehörigen dazwischen liegenden Knotenpunkten (67, 68) definieren,
eine zweite Gruppe von Widerständen, die in Reihe geschaltet sind und eine zweite Gruppe von zugehörigen dazwischen liegenden Knotenpunkten (77, 78) definieren,
einen zwischen die erste Gruppe und die zweite Gruppe gekoppelten mittleren Widerstand (RMID), wobei
jeder der ersten Vielzahl von Schalter-Schaltkreisen mit einem entsprechenden der ersten Gruppe von dazwischen liegenden Knotenpunkten verbunden ist und
jeder der zweiten Vielzahl von Schalter-Schaltkreisen mit einem entsprechenden der zweiten Gruppe von dazwischen liegenden Knotenpunkten verbunden ist.

3. Programmierbarer Transkonduktor entsprechend Anspruch 2, wobei die erste und die zweite Gruppe von Widerständen symmetrisch sind.

4. Programmierbarer Transkonduktor entsprechend Anspruch 1, wobei die erste und die zweite Vielzahl der Schalter-Schaltkreise CMOS-Transfer-Gate-Schaltungen aufweist.

5. Programmierbarer Transkonduktor entsprechend Anspruch 4, wobei die CMOS-Transfer-Gate-Schaltungen durch digitale Steuersignale freigegeben werden.

6. Programmierbarer Transkonduktor entsprechend Anspruch 1 oder Anspruch 2, wobei jeder der ersten Eingänge des ersten und zweiten Verstärkerblocks einen nicht-invertierenden Eingang (42, 45) aufweist und
wobei jeder der zweiten Eingänge des ersten und zweiten Verstärkerblocks einen invertierenden Eingang aufweist.

7. Programmierbarer Transkonduktor entsprechend Anspruch 1, wobei jeder des ersten und zweiten Transistors (46, 56) einen Transistor aufweist, der aus einer Gruppe ausgewählt ist, die aus einem P-Kanal-MOS-Transistor, einem N-Kanal-MOS-Transistor, einem PNP-Bipolar-Transistor und einem NPN-Bipolar-Transistor besteht.

8. Programmierbarer Transkonduktor entsprechend Anspruch 6, wobei der erste Transistor einen P-Kanal-MOS-Transistor aufweist mit einem mit dem ersten Summierknotenpunkt verbundenen Source/Drain-Anschluss, einem mit dem Ausgang des ersten Verstärkerblocks verbundenen Gate-Anschluss und einem mit dem ersten Stromausgangsanschluss verbundenen Drain/Source-Anschluss und
wobei der zweite Transistor einen P-Kanal-MOS-Transistor aufweist mit einem mit dem zweiten Summierknotenpunkt verbundenen Source/Drain-Anschluss, einem mit dem zweiten Summierknotenpunkt verbundenen Gate-Anschluss, einem mit dem Ausgang des zweiten Verstärkerblocks verbundenen Gate-Anschluss und einem mit dem zweiten Stromausgangsanschluss verbundenen Drain/Source-Anschluss.

9. Programmierbarer Transkonduktor entsprechend Anspruch 8, wobei die erste und zweite Gruppe der Transistoren symmetrisch sind.

10. Programmierbarer Transkonduktor entsprechend Anspruch 9, wobei die erste und die zweite Vielzahl der Schalter-Schaltkreise CMOS-Transfer-Gate-Schaltungen aufweisen, die durch digitale Steuersignale freigegeben werden.

## Revendications

1. Transducteur programmable pour produire un courant différentiel entre une première borne de sortie de courant et une deuxième borne de sortie de courant, dans lequel le courant différentiel réagit à une tension différentielle engendrée de façon opérationnelle entre une première borne d'entrée de tension et une deuxième borne d'entrée de tension, dans lequel :
un circuit (30) source de courant est configuré pour fournir une quantité déterminée à l'avance de courant, dans chacun d'un premier noeud de sommation et d'un deuxième noeud de sommation ;
un premier bloc (44) de gain a une première entrée couplée à la première borne d'entrée de tension, une deuxième entrée couplée à un premier noeud (60) de rétroaction et une sortie ;
un premier transistor (46) a une première borne de tenue en courant couplée au premier noeud de sommation, une deuxième borne de tenue en courant couplée à la première borne de sortie de courant et une borne de commande couplée à la sortie du premier bloc de gain ;
un deuxième bloc (54) de gain a une première entrée couplée à la deuxième borne d'entrée de tension, une deuxième entrée couplée à un deuxième noeud (70) de rétroaction et une sortie ; et
un deuxième transistor (56) a une première borne de tenue en courant couplée à un deuxième noeud de sommation, une deuxième borne de tenue en courant couplée à la deuxième borne de sortie de courant et une borne de commande couplée à la sortie du deuxième bloc de gain,
un circuit (RMID, R1, R2) résistif est couplé entre le premier noeud de sommation et le deuxième noeud de sommation, le circuit résistif comprenant une pluralité de résistances individuelles montées en série et définissant une pluralité de noeuds intermédiaires entre des résistances voisines ; **caractérisé par**:
une première pluralité de circuits (S1, S2, S3) de commutation ayant chacun une première borne couplée à un noeud correspondant du circuit (36, 67, 68) résistif et ayant chacun en outre, une deuxième borne couplée au premier noeud (60) de rétroaction ; et
une deuxième pluralité de circuits (S1, S2, S3) de commutation ayant chacun une première borne couplée à un noeud (38, 77, 78) correspondant du circuit résistif et ayant chacun en outre, une deuxième borne couplée au deuxième noeud (70) de rétroaction ; dans lequel :
le circuit résistif et la pluralité de circuits de commutation sont configurés pour produire un gain de transconductance programmable.

2. Transducteur programmable suivant la revendication 1, dans lequel la pluralité de résistances individuelles comprend :
un premier groupe de résistances montées en série et définissant un premier groupe de noeuds (67, 68) intermédiaires associés à celles-ci ;
un deuxième groupe de résistances montées en série et définissant un deuxième groupe de noeuds (77, 78) intermédiaires associés à celles-ci ;
une résistance intermédiaire (RMID) couplée entre le premier groupe et le deuxième groupe, dans lequel :
chaque circuit de la première pluralité de circuits de commutation est couplé à l'un respectif des noeuds intermédiaires du premier groupe ; et
chaque circuit de la deuxième pluralité de circuits de commutation est couplé à l'un respectif des noeuds intermédiaires du deuxième groupe.

3. Transducteur programmable suivant la revendication 2, dans lequel les premier et deuxième groupes de résistances sont équilibrés.

4. Transducteur programmable suivant la revendication 1, dans lequel les première et deuxième pluralités de circuits de commutation comprennent des circuits CMOS en portes de transfert.

5. Transducteur programmable suivant la revendication 4, dans lequel les circuits CMOS en portes de transfert sont validés par des signaux d'asservissement numérique.

6. Transducteur programmable suivant la revendication 1 ou 2, dans lequel chacune des premières entrées des premier et deuxième blocs de gain comprend une entrée (42, 45) non inverseuse ; et
dans lequel chacune des deuxièmes entrées des premier et deuxième blocs de gain comprend une porte inverseuse.

7. Transducteur programmable suivant la revendication 1, dans lequel chacun des premier et deuxième transistors (46, 56) comprend un transistor choisi à partir d'un groupe composé de transistors MOS à canal P, de transistors MOS à canal N, de transistors bipolaires PNP et de transistors bipolaires NPN.

8. Transducteur programmable suivant la revendication 6, dans lequel le premier transistor comprend un transistor MOS à canal P ayant une borne source-drain couplée au premier noeud de sommation, une borne grille couplée à la sortie du premier bloc de gain et une borne drain-source couplée à la première borne de sortie de courant ; et
dans lequel le deuxième transistor comprend un transistor MOS à canal P ayant une borne source-drain couplée au deuxième noeud de sommation, une borne grille couplée au deuxième noeud de sommation, une borne grille couplée à la sortie du deuxième bloc de gain et une borne drain-source couplée à la deuxième borne de sortie de courant.

9. Transducteur programmable suivant la revendication 8, dans lequel les premier et deuxième groupes de résistances sont équilibrés.

10. Transducteur programmable suivant la revendication 9, dans lequel les première et deuxième pluralités de circuits de commutation comprennent des circuits CMOS en portes de transfert, validés par des signaux d'asservissement numérique.
